# EUROPEAN PATENT SPECIFICATION

(11) **EP 1 638 210 B1**
(45) Date of publication and mention of the grant of the patent: **06.05.2009**
(21) Application number: 04077551.2
(22) Date of filing: 15.09.2004
(51) Int. Cl.: H04B 1/04, H03D 7/16, H03C 3/40

(54) **VLIF transmitter for a "Bluetooth Wireless Technology" device**
VLIF-Sender für eine "Bluetooth Wireless Technology" Vorrichtung
Emetteur VLIF pour un dispositif "Bluetooth Wireless Technology"

(43) Date of publication of application: 22.03.2006
(73) Proprietor: STMicroelectronics Belgium N.V., 1930 Zaventem (BE)
(72) Inventor: Borremans, Marc, 3060 Korbeek-Dijle (BE); Goetschalckx, Paul, 2860 Sint-Katelijne-Waver (BE); Monterastelli, Andrea, 55029 Ponte a Moriano Lucca (IT)
(74) Representative: Bird, Ariane

(56) References cited:
- EP-A- 1 160 968
- US-A1- 2004 018 820
- GILB J P K ED - CAMILLERI N (ED): "BLUETOOTH RADIO ARCHITECTURES" 2000 IEEE RADIO FREQUENCY INTEGRATED CIRCUITS (RFIC) SYMPOSIUM. DIGEST OF PAPERS. BOSTON, MA, JUNE 11-13, 2000, IEEE RADIO FREQUENCY INTEGRATED CIRCUITS SYMPOSIUM, NEW YORK, NY : IEEE, US, 11 June 2000 (2000-06-11), pages 3-7, XP002906993 ISBN: 0-7803-6281-0

## Description

**Field of the invention:** This invention relates to RF transmitter devices, to transceivers, to integrated circuits, portable devices having such transmitters, and to methods of producing signals using such transmitters.

### Description of the Related Art:

A number of known radio systems use transmissions at the same frequency or different frequencies in different time slots. Frequency domain/time-division-multiple-access (FDMA-TDMA) systems include Digital European Cordless Telecommunications (DECT), Global System for Mobile Communications (GSM), and Bluetooth^{®} Wireless Technology, hereinafter 'Bluetooth'. Bluetooth is a well known short-range radio link intended to replace the cable(s) connecting portable and/or fixed electronic devices. Full details are available from Bluetooth SIG which has its global headquarters in Overland Park, Kansas, USA. Key features are robustness, low complexity, low power, and low cost. Bluetooth operates in the unlicensed ISM band at 2.4 GHz. A frequency hop transceiver is applied to combat interference and fading. A time slotted channel is applied with a nominal slot length of 625 µs. 79 channels are used, with 1 MHz per channel (2.402, 2.403, ..., 2.480 GHz). On each channel, information is exchanged through packets. Each packet is transmitted on a different hop frequency. The Bluetooth protocol uses a combination of circuit and packet switching. Slots can be reserved for synchronous packets. The Bluetooth system can provide a point-to-point connection (only two Bluetooth units involved), or a point-to-multipoint connection. Bluetooth transmitters hop from one RF frequency to another many times a second and have a short time to settle at the new frequency.

Suitable RF transmitters can be integrated using a number of different topologies. These topologies can be distinguished based on the implementation of the main functionalities:
1) Generation of a modulated digital base-band signal, or modulation of a local oscillator signal with the base-band signal (e.g. direct VCO modulation or IQ modulation).
2) Generation of a local oscillator signal.
3) The type of power amplifier used.

For an IQ modulation topology and where the local oscillator is at the application's channel center frequency, the RF output component is near to the LO frequency, which can result in a frequency pulling of the local oscillator.

For this reason often an oscillator at double the channel frequency is used in combination with a divide-by-2 circuit. However, also in this topology, frequency pulling appears due to coupling of the second harmonic components of the RF signal to the oscillator. It is known to avoid this RF coupling from the transmitter to oscillator that causes the pulling of the oscillator, by choosing a different topology. For a simple frequency modulation, a direct modulation of the LO could be selected avoiding this pulling problem. For an IQ modulation topology, it is known in literature, that the pulling effect is reduced when the frequency difference between the oscillator frequency and the injected component (coupling from the transmitter output) is increased. Therefore, the pulling can be reduced by using an intermediate frequency topology.

Solutions based on an intermediate frequency and on using filters to eliminate image and other distortion components has a severe drawback for integration. These filters require expensive external components and are not suited for low-cost on-chip integration. An alternative exists in using an intermediate frequency at a low multiple of the channel bandwidth or at a multiple of half the channel bandwidth. In this case, any IF harmonic distortion components, carrier component (spurious components) are not filtered and degrade the adjacent channel power performance. The position of these components in the TX output spectrum depend on the choice of IF frequency.

It is known from EP 1160968 that new cellular standards such as EDGE and EDGE phase II require transmitters with low error vector magnitude (EVM) in order to limit the link level degradation for high-speed data transmission. It also shows IQ modulator circuitry having as input I and Q output signals at a low IF value and a LO signal at a second IF and producing a signal having a reduced image level and a reduced IF LO leakage prior to transmission. One embodiment has a very low IF value in the range of the channel spacing/10 to the channel spacing/2 and the signal produced has a reduced image level displaced by twice the low IF value without compromising the output spectrum.

US 2004/018820 shows an example of Bluetooth ® Wireless technology where digital transmission formatted data will be a digital base-band signal or a digital low IF signal, and where the low IF typically will be in the frequency range of one hundred kilohertz to a few megahertz.

### Summary of the Invention:

An object of the invention is to provide improved apparatus or methods especially for RF transmitter devices, RF transceivers, integrated circuits for RF devices, portable devices having such transmitters, and methods of producing signals using such transmitters.

According to a first aspect, the invention provides an RF transmitter as set out in claim 1. Some further embodiments are set out in dependent claims.

The use of a Very-Low-Intermediate-Frequency transmitter with a Very-Low-IF-frequency fIF smaller than half the channel bandwidth: 0< fIF <BW/2 can help enable a good margin on adjacent channel power and a reduced pulling effect on the local RF oscillator to be achieved. It can also enable more complex modulation schemes compared to direct modulation topologies.

An additional feature of the present invention is a fractional PLL circuit for generating the RF local oscillator signal for the RF modulation. For example, the LO frequency can be compensated for this f_{IF} in the fractional PLL. If the IF is e.g. 420 kHz and the channel frequency is at e.g. 2402 MHz, the LO frequency is at 2402MHz-430kHz=2401.57MHz. The oscillator is set to oscillate at this frequency or at twice this frequency for the double frequency +div-by-2 topology. This change in frequency is implemented by a different control input of a fractional PLL.

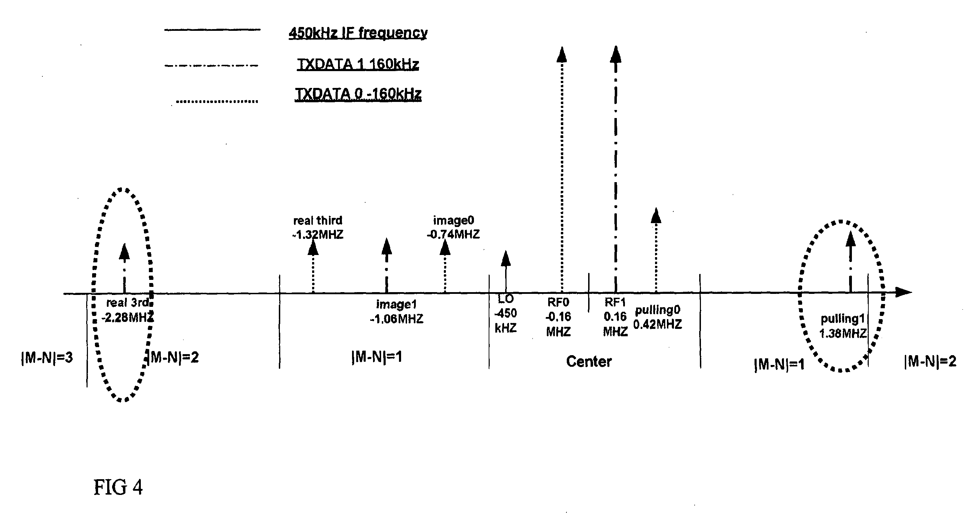

Another additional feature is the channel bandwidth being 1 MHz or less. Comparing Table 1 with Figure 4 below shows that for the example of Bluetooth, an IF frequency smaller than 500kHz i.e. channel BW/2, the main distortion components image, carrier, pulling for both 0 and 1 frequency modulated signal are in a part of the spectrum with a more relaxed adjacent channel power specification with M=2 (20dBm).

Another additional feature is the f_{IF} being selected such that spurious components at frequencies based on integer multiples of a baseband frequency, in an RF output spectrum, are positioned in a frequency band of an adjacent channel. In particular, such spurious components (1LO.×BB with x:-3,-2,....,+3) in an RF output spectrum are positioned in a frequency band with less stringent specifications for adjacent channel power.

Another additional feature is the transmitter being a Bluetooth transmitter. Another additional feature is the transmitter being incorporated in a transceiver IC with digital baseband processing, digital baseband modulation and demodulation functions, an analog IF section and RF modulation and demodulation functions.

Another aspect of the invention is an integrated circuit for an RF transmitter. Another aspect is a portable wireless product having the transmitter. Another aspect of the invention is a method of producing signals using the transmitter. Another aspect provides an RF transmitter suitable for Bluetooth transmissions and having an IF modulator for generating an IF modulated signal, and having an RF modulator, the RF modulator being arranged to generate RF signals on a number of frequency channels, from the IF modulated signal, the IF modulator being arranged to use a very-low-IF-frequency f_{IF}, such that main or significant spurious unwanted modulation components, e.g. at f_{LO}.xf_{BB} [x:-3...3], fall in channels having a channel number smaller than (i.e. within) three of a channel being transmitted, e.g. zero, one or two channel numbers away.

Embodiments of the invention can combine easier integration and reduction of the pulling effect with an increased margin on the adjacent channel power specification compared to using an intermediate frequency at a low multiple of the channel bandwidth or at a multiple of half the channel bandwidth. Particularly for the Bluetooth application, the choice of IF frequency in combination with the channel frequency plan can give the advantage that the main non-filtered spurious components (1LO.xBB with x:-3,-2,....,+3) in the TX output spectrum are positioned in the frequency bands with the least-stringent specifications for adjacent channel power.

To reduce the VCO pulling problem and to overcome the adjacent channel power degradation when using a (half-)channel BW multiple as IF frequency, the PLL's fractionality is used in order to optimize the adjacent power frequency plan by selecting the most appropriate IF frequency.

This can give significant improvement of the pulling compared to zero-IF (experiments showed a 10 to 15 dB improvement). Significant improvement of the margin on adjacent channel power for specific distortion components can arise because these components are located in a channel with 20dB less stringent specifications. (So for same TX output power, 20 dB more margin).

Any of the additional features can be combined together and combined with any of the aspects. Other advantages will be apparent to those skilled in the art, especially over other prior art. Numerous variations and modifications can be made without departing from the claims of the present invention. Therefore, it should be clearly understood that the form of the present invention is illustrative only and is not intended to limit the scope of the present invention.

### Brief Description of the Drawings:

How the present invention may be put into effect will now be described by way of example with reference to the appended drawings, in which:
Figure 1 shows a transmitter according to an embodiment of the invention,
Figure 2 shows for reference a graph of a TX output spectrum for 0/1 (FM modulated) data at 0 kHz IF, that is direct modulated, where channel bandwidth is 1 MHz,
Figure 3 shows for reference a graph of a TX output spectrum for 0/1 (FM modulated) data at 1000 kHz IF, again where channel bandwidth is 1 MHz and
Figure 4 shows a graph of a TX output spectrum for 0/1 (FM modulated) data at 450 kHz IF (less than half the channel bandwidth) according to an embodiment of the invention.

### Description of the Preferred Embodiments:

The present invention will now be described with reference to certain embodiments and with reference to the above mentioned drawings. Such description is by way of example only and the invention is not limited thereto.

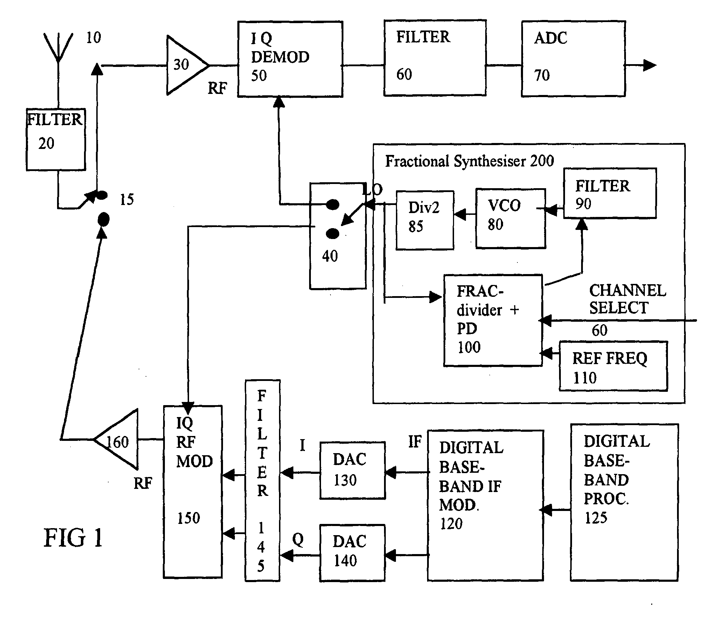

A first embodiment of the invention, illustrated in fig 1 shows an example of a transceiver having a transmitter according to an embodiment of the invention. It is suitable for Bluetooth or similar wireless specifications. Such description is by way of example only and the invention is not limited thereto. It will be noted, however, that all the embodiments of the present invention can be used with the Bluetooth™ protocol. The features of such a system may include one or more of
- Slow frequency hopping as a spread spectrum technique;
- Master and slave units whereby the master unit can set the hopping sequence;
- Each device has its own clock and its own address;
- The hopping sequence of a master unit can be determined from its address;
- A set of slave units communicating with one master all have the same hopping frequency (of the master) and form a piconet;
- Piconets can be linked through common slave units to form a scatternet;
- Time Division Multiplex Transmissions (TDMA) between slave and master units;
- Time Division Duplex (TDD) transmissions between slaves and masters units;
- Transmissions between slave and master units may be either synchronous or asynchronous;
- Master units determine when slave units can transmit;
- Slave units may only reply when addressed by a master unit;
- The clocks are free-running;
- Uncoordinated networks, especially those operating in the 2.4 GHz license-free ISM band;
- A software stack to enable applications to find other Bluetooth™ devices in the area;
- Other devices are found by a discovery/inquiry procedure; and
- Hard or soft handovers.

With regard to frequency hopping, "slow frequency hopping" refers to the hopping frequency being slower than the modulation rate, "fast frequency hopping" referring to a hopping rate faster than the modulation rate. The present invention is not limited to either slow or fast hopping.

Returning to Fig. 1, the transmitter includes an optional digital base band processing part 125, for generating the data to be transmitted. This is passed to an IF modulator part 120 for modulating the data with a very low frequency IF frequency to produce an IF signal. In this case, the modulation is achieved in the digital domain and produces I and Q outputs, though other schemes are possible. As described in more detail below with reference to fig 4, the IF frequency is chosen to be less than half the channel bandwidth. This enables spurious components to be located in more favorable parts of the spectrum, closer to the wanted signal. This is more favorable because standards such as the Bluetooth standard specify that more cross channel interference can be tolerated between channels closer together.

The IF I and Q signals are converted to analog signals by DACs 130 and 140 respectively and optionally filtered. For example, these analog signals are first filtered at 145 to remove the DAC alias and other high frequency components thus preventing these to be modulated to RF frequency, and are then fed to the RF modulator 150 to produce RF signals. These are amplified by power amplifier 160 and fed via switch 15 and an external band filter filter 20 in the common Receive-Transmit signal path to antenna 10. The RF modulator uses a local oscillator signal LO which has a frequency which determines which channel is transmitted. The local oscillator generator (also called a synthesizer) typically has a fractional phase lock loop PLL 200. A fractional PLL is often preferred to a synthesizer having an integer-N type PLL, which switches frequencies by integer multiples of the internal reference frequency (FREF) 110. This FREF is usually generated by dividing down a crystal oscillator using a reference divider located prior to an analog phase detector. In the integer-N system, the analog phase detector of the PLL compares two inputs, FREF and an integer-N divider output, which is the divided down voltage-controlled oscillator (VCO 80) output frequency. The phase detector adjusts the voltage to the VCO until both inputs are equal in phase or phase-locked. In case of a VCO running at twice the LO frequency an divide-by-2 circuit 85 is used. To generate a desired VCO frequency, the integer-N divider divides the VCO frequency by a value (N). To generate an output frequency of 1000 MHz with a step size of 1 MHz, FREF is 1 MHz (FREF is equal to step size in an integer-N synthesizer) and N is 1,000. To achieve a finer step size without poor phase noise characteristics, a fractional PLL is used. Instead of having an integer-N divider, the frac-N PLL has a fractional-N divider. A loop filter 90 is also included to help make frequency changes more stable, when the channel is changed, controlled by a channel select signal from control circuitry (not shown). A useful reference for PLL's is the book by R. E. Best, "Phase-Locked Loops" Fifth Edition, McGraw-Hill, 2003.

An optional div/2 block 85 is provided after the VCO 80. The optional div2 block is in case a double frequency VCO is used.

On the receive side, the switch 15 sends received RF signals through a filter 20, a low noise amplifier 30, to an IQ demodulator 50. This uses the local oscillator signal LO, fed by switch 40. The demodulated outputs are fed via filter 60 to ADC 70. Optionally the digital signals from the ADC may be fed to further demodulation circuitry depending on the application, or to further processing stages. The transceiver can be integrated entirely in a single IC, or divided across multiple ICs as desired. It can be incorporated in wireless mobile devices such as battery powered mobile telephones or mobile computing or display or multimedia devices for example.

**Table 1 : Requirements on adjacent channel power for the Bluetooth standard.**

| |
|---|
| **Bluetooth spectral density specifications** |
| **Channel \|M-N\|=0** |
| 20dBc BW < +/-500kHz from the 20 dB BW test |
| **Channel \|M-N\|=1** |
| No spec from adjacent channel power |
| Spec implied by the 20dBc from the 20 dB BW test |
| **Channel \|M-N\|=2 :** |
| P<-20dBm |
| From adjacent channel power spec |
| **Channel \|M-N\|>2** |
| P<-40dBm |
| From adjacent channel power spec |

This table shows the amount of spurious power from adjacent channels which can be tolerated. When the channel number differs by 1, (M-N =1) then more spurious power can be tolerated. When the channel number differs by more than 2, there is less tolerance for spurious power. The embodiments described below exploit this insight by arranging the IF frequency so that unwanted artifacts in the spectrum fall into adjacent channels where M-N is 1 or 2 so that there is more tolerance for them, and less need to suppress such artifacts.

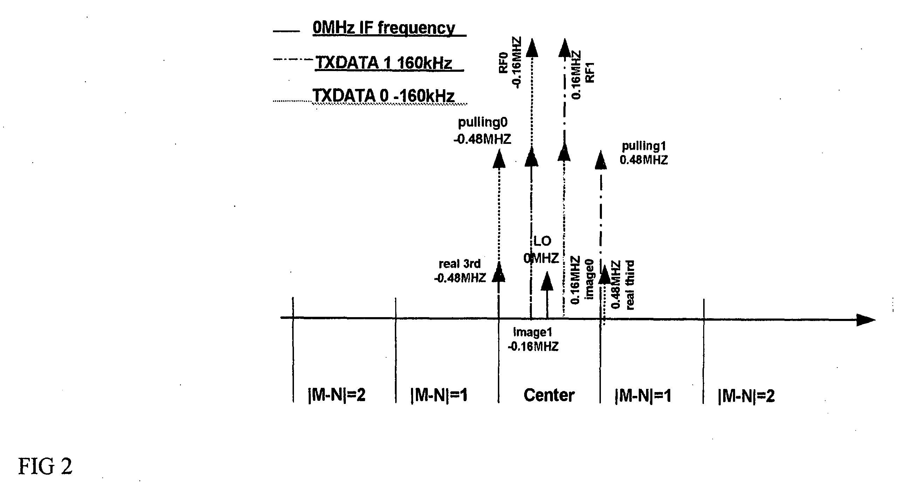

Figure 2 is included for reference and shows a problem with a known arrangement using a direct conversion (IF=0Hz) transmitter topology with no IF modulator. It shows a graph of a transmitter output frequency spectrum for 0/1 (FM modulated) data where there is no IF modulator, in other words, IF = 0 kHz. The simplified schematic graph shows the main spurious components at 1LO.xBB (x:-3...+3). The output is symmetric around the channel center for 0/1 data. The indicated frequency offsets are relative to the channel center. The pulling and the image components are assumed to be caused by parasitic coupling from the transmitter to the oscillator. This is exacerbated by use of highly integrated devices with more components on the same substrate.

The nomenclature used is for the spurs is as follows:

| **Name** | **Line** | **Frequency** | **Txdata** | **Remark** |
|---|---|---|---|---|
| RF0 | Gray | Channel center - f_{BB} =f_{LO}+f_{IF}-f_{BB} | Continuous 0 | Wanted signal |
| **RF1** | Black | Channel center +f_{BB} =f_{LO}+f_{IF}+f_{BB} | Continuous 1 | Wanted signal |
| **LO** | Black | Channel center - f_{IF} =f_{LO} | | Carrier |
| **Image0** | Gray | f_{LO}- (f_{IF}-f_{BB}) | Continuous 0 | Normally rejected by IQ modulation, value determined by on-chip matching accuracy but can be dominated by VCO pulling component |
| **Image1** | Black | f_{LO}- (f_{IF}+f_{BB}) | Continuous 1 | Idem |
| **Real third** | Gray | f_{LO} - 3.(f_{IF}-f_{BB}) | Continuous 0 | Main distortion component due to non linearity of the mixer and/or the analog baseband. |
| **Real third** | Black | f_{LO} - 3.(f_{IF}+f_{BB}) | Continuous 1 | Idem |
| **Pulling0** | Gray | f_{LO} + 3.(f_{IF}-f_{BB}) | Continuous 0 | Normally rejected by the IQ modulation, but a dominant component in case of VCO pulling |
| **Pulling1** | Black | f_{LO} + 3.(f_{IF}+f_{BB}) | Continuous 1 | Idem |
| | | | | |

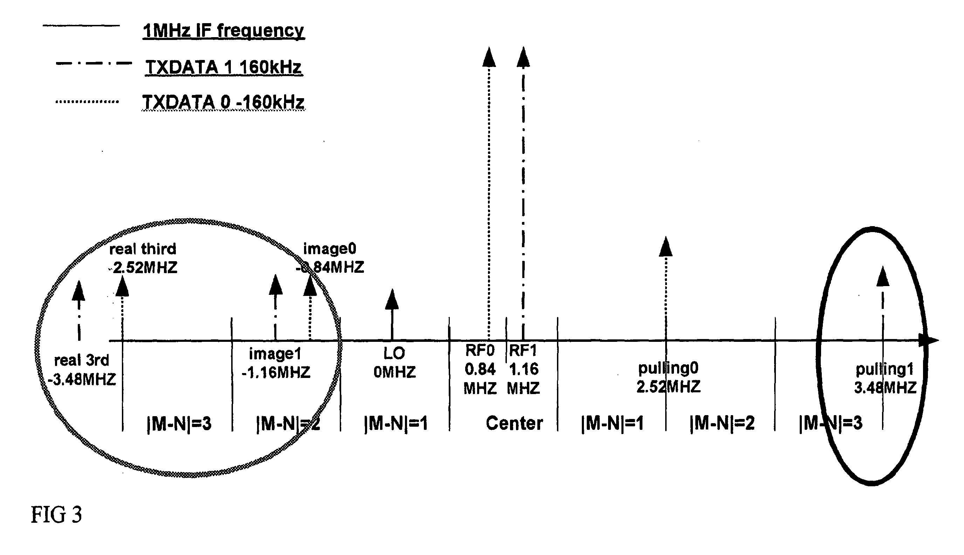

Figure 3 shows a similar graph of transmitter output spectrum for 0/1 (FM modulated) data, but this time at a higher IF of 1000 kHz, which corresponds to a value equal to the channel bandwidth. It shows a simplified schematic of the main spurious components at 1LO.xBB (x:-3...+3). The indicated frequency offsets are relative to the LO frequency. To get the offset relative to the channel center, 1MHz has to be subtracted from each number. The output is no longer symmetric around the channel center for 0/1 data. The pulling and the image components are strongly reduced by the frequency offset between oscillator and the 2Rf frequency. However several spurious distortion components are positioned in the frequency band where the ―40dBm adjacent power specification applies. These are circled in the figure for emphasis. These are the channels where the difference between channel numbers M-N is greater than two. These unwanted distortion components need to be suppressed. The image components have also been circled to indicate that for higher IF frequency (>1.5MHz) these are also located outside the intended band with |M-N|<3.

Figure 4 shows a similar graph of transmitter output spectrum for 0/1 (FM modulated) data, but for an embodiment of the invention, where IF=450 kHz, in other words the IF is less than half the channel bandwidth. It shows a simplified schematic of the main spurious components at 1LO.xBB (x = -3, -2, ...+3), superimposed on the Bluetooth channel allocation. The indicated frequency offsets are relative to the channel center. As in figs 2 and 3, the lighter arrows represent the wanted and unwanted components from the transmission of a "zero". The zeroes are transmitted at 160kHz below the channel centre frequency, set by the LO. The darker arrows represent wanted and unwanted components from the transmission of a "one". The ones are transmitted at 160kHz above the centre frequency. The output is not symmetric around the channel center for 0/1 data. The pulling and the image components are still strongly reduced by the frequency offset between oscillator and the 2RF frequency. The spurious distortion components are NOT positioned in the frequency band where the ―40dBm adjacent power specification applies, but in a band where more relaxed specifications apply. Thus these components need not be suppressed as much as the corresponding components shown in figure 2.

The circuitry can be implemented in conventional hardware and use integrated circuit technology following established practice which need not be described here in more detail. Digital processing parts can be implemented using application specific logic or software running on processing circuitry, the software being written in a conventional language. Although described for wireless applications transmitting through air, RF transmitters can also be used for transmitting along waveguides.

As has been described above, an RF transmitter suitable for Bluetooth transmissions has an IF modulator (120) and an RF modulator (150), the IF modulator being arranged to use a very-low-IF-frequency f_{IF}, smaller than half the channel bandwidth, such that spurious unwanted modulation components fall in other channels having a channel number within one or two of a channel being transmitted. This can reduce the VCO pulling problem and reduce adjacent channel power degradation compared to using higher IF frequencies. The local oscillator PLL's fractionality is used in order to optimize the adjacent power frequency plan by selecting the most appropriate IF frequency. For the Bluetooth application, the IF frequency is < 500kHz, and the main non-filtered spurious components (1LO.xBB with x:-3,-2,....,+3) image, carrier, pulling, for both 0 and 1 FM signals, are positioned in frequency bands of adjacent channels.

## Claims

1. An RF transmitter suitable for transmissions according to the Bluetooth specifications, which specifications establish a higher specified tolerance levels for spurious power from adjacent channels whose channel numbers differ by less than three from a channel number of a channel being transmitted, compared to channels whose channel numbers differ by three or more, wherein each channel has a predetermined bandwidth and is identified by a progressive number having an IF modulator (120) for generating an IF modulated signal, and having an RF modulator (150), the RF modulator being arranged to generate RF signals on a number of frequency channels, from the IF modulated signal, the IF modulator being arranged to use a very-low-IF-frequency (fIF) smaller than half a bandwidth of the channel and larger than zero, such that spurious unwanted modulation components represented by 1LO.xBB for x=:-3,-2,....+3, where LO is Local Oscillator frequency, and BB is the frequency of the baseband signal, fall in channels having a channel number which differs by less than three from a channel number of a channel being transmitted.

2. The transmitter of claim 1, having a fractional PLL circuit (100) for generating the RF local oscillator signal for the RF modulation.

3. The transmitter of any preceding claim, the channel bandwidth being I MHz or less.

4. The transmitter of any preceding claim, the very-low-IF-frequency (fIF) being selected such that spurious components at frequencies based on integer multiples of a baseband frequency, in an RF output spectrum, are positioned in a frequency band of an adjacent channel.

5. A transceiver having the transmitter of any preceding claim, and having circuitry for digital baseband processing (125), for analog IF functions (60, 70, 130, 140) and for RF modulation (1 50) and demodulation (50) functions.

6. An integrated circuit having the transmitter of any of claims 1 to 4 or the transceiver of claim 5.

7. A portable wireless product having the transmitter of any of claims 1 to 4.

8. A method of producing signals using the transmitter of any of claims 1 to 4.

## Patentansprüche

1. RF-Sender für Übertragungen gemäß den Bluetooth-Spezifikationen, welche höhere spezifizierte Toleranzpegel für Störleistungen von benachbarten Kanälen spezifizieren, deren Kanalnummern sich um weniger als drei von einer Kanalnummer eines übertragenden Kanals unterscheiden, im Vergleich zu Kanälen, deren Kanalnummern sich um drei oder mehr unterscheiden, wobei jeder Kanal eine vorbestimmet Bandbreite aufweist und durch eine progressive Zahl identifizierbar ist, mit einem IF-Modulator (120) zum Erzeugen eines IF-modulierten Signals und mit einem RF-Modulator (150), wobei der RF-Modulator eingerichtet ist, RF-Signale auf einer Anzahl von Frequenzkanälen aus dem IF-modulierten Signal zu erzeugen, wobei der IF-Modulator eingerichtet ist, eine sehr niedrige IF-Freuquenz (fIF) kleiner als eine halbe Bandbreite des Kanals und größer als Null zu verwenden, so dass ungewollte Störmodulationskomponenten dargestellt durch 1LO.xBB für x=: -3, -2,..., +3, wobei LO die lokale Oszillatorfrequenz und BB die Frequenz des Basisbandsignals ist, in Kanäle fallen mit einer Kanalnummer, welche sich um weniger als drei von einer Kanalnummer des übertragenden Kanals unterscheiden.

2. Sender nach Anspruch 1 mit einer fraktionalen PLL-Schaltung (100) zum Erzeugen des RF-Signals des lokalen Oszillators für die RF-Modulation.

3. Sender nach einem der vorhergehenden Ansprüche, wobei die Kanalbandbreite 1 MHz oder weniger beträgt.

4. Sender nach einem der vorhergehenden Ansprüche, wobei die sehr niedrige IF-Frequenz (fIF) derart ausgewählt ist, dass Störkomponenten bei Frequenzen basierend auf gradzahligen Vielfachen einer Basisbandfrequenz in einem RF-Ausgabespektrum in einem Frequenzband eines benachbarten Kanals positioniert sind.

5. Sende-/Empfangsvorrichtung mit einem Sender nach einem der vorhergehenden Ansprüche und mit einer Schaltungsanordnung zur digitalen Basisbandverarbeitung (125) für analoge IF-Funktionen (60, 70, ,130, 140) und für RF-Modulations (150) - und Demodulations (50) -Funktionen.

6. Integrierte Schaltung mit dem Sender nach einem der Ansprüche 1 bis 4 oder der Sende-/Empfangseinrichtung nach Anspruch 5.

7. Tragbares drahtloses Produkt mit dem Sender nach einem der Ansprüche 1 bis 4.

8. Verfahren zum Erzeugen von Signalen unter Verwendung des Senders nach einem der Ansprüche 1 bis 4.

## Revendications

1. Émetteur HF approprié pour des transmissions selon les spécifications Bluetooth, lesquelles spécifications établissent des niveaux de tolérance spécifiés plus élevés pour la puissance parasite provenant de canaux adjacents dont les numéros de canal diffèrent de moins de trois d'un numéro de canal d'un canal en cours de transmission, en comparaison à des canaux dont les numéros de canal diffèrent de trois ou plus, dans lequel chaque canal a une bande passante prédéterminée et est identifié par un numéro progressif, ayant un modulateur FI (120) pour produire un signal modulé FI, et ayant un modulateur HF (150), le modulateur HF étant agencé pour produire des signaux HF sur un certain nombre de canaux de fréquence, à partir du signal modulé FI, le modulateur FI étant agencé pour utiliser une fréquence FI très basse (fFI) plus petite que la moitié d'une bande passante du canal et plus grande que zéro, de sorte que les composantes de modulation indésirables parasites représentées par 1LO.xBB pour x =: -3, -2, ..., +3, où LO est la fréquence d'Oscillateur Local et BB est la fréquence du signal en bande de base, tombent dans des canaux ayant un numéro de canal qui diffère de moins de trois par rapport à un numéro de canal d'un canal en cours de transmission.

2. Émetteur selon la revendication 1, ayant un circuit PLL fractionnaire (100) pour produire le signal d'oscillateur local HF pour la modulation HF.

3. Émetteur selon l'une quelconque des revendications précédentes, la bande passante de canal étant de 1 MHz ou moins.

4. Émetteur selon l'une quelconque des revendications précédentes, la fréquence FI très basse (fFI) étant sélectionnée de sorte que les composantes parasites à des fréquences basées sur des multiples entiers d'une fréquence de bande de base, dans un spectre de sortie HF, sont positionnées dans une bande de fréquence d'un canal adjacent.

5. Émetteur-récepteur ayant l'émetteur selon l'une quelconque des revendications précédentes, et ayant des circuits pour le traitement numérique en bande de base (125), pour des fonctions FI analogiques (60, 70, 130, 140) et pour des fonctions de modulation (150) et de démodulation (50) HF.

6. Circuit intégré ayant l'émetteur selon l'une quelconque des revendications 1 à 4 ou l'émetteur-récepteur selon la revendication 5.

7. Produit sans fil portatif ayant l'émetteur selon l'une quelconque des revendications 1 à 4.

8. Procédé de production de signaux utilisant l'émetteur selon l'une quelconque des revendications 1 à 4.
